# EUROPÄISCHE PATENTSCHRIFT

(11) **EP 2 731 217 B1**
(45) Veröffentlichungstag und Bekanntmachung des Hinweises auf die Patenterteilung: **01.03.2017**
(21) Anmeldenummer: 13191148.9
(22) Anmeldetag: 31.10.2013
(51) Int. Cl.: H02H 3/04, H02H 3/33, G01R 31/327

(54) **Verfahren und Vorrichtung zur Überwachung eines Prüfintervalls für eine Fehlerstrom-Schutzeinrichtung**
Method and device for monitoring a test interval for a residual current protection device
Procédé et dispositif de surveillance d'un intervalle de contrôle pour un dispositif de protection à courant différentiel

(30) Priorität: 13.11.2012 DE 102012220692
(43) Veröffentlichungstag der Anmeldung: 14.05.2014
(73) Patentinhaber: Bender GmbH & Co. KG, 35305 Grünberg (DE)
(72) Erfinder: Hackl, Dieter, Dipl.-Ing., 35463 Fernwald (DE)
(74) Vertreter: advotec.

(56) Entgegenhaltungen:
- EP-A2- 1 571 686
- DE-A1- 19 511 795
- US-A1- 2008 007 879
- US-A1- 2010 052 691

## Beschreibung

Die Erfindung betrifft ein Verfahren zur Überwachung eines Prüfintervalls für eine Fehlerstrom-Schutzeinrichtung, umfassend die wiederholt ausgeführten Verfahrensschritte: Messen einer Betriebsdauer der Fehlerstrom-Schutzeinrichtung, Auslösen einer Alarmmeldung, falls die gemessene Betriebsdauer einen Betriebsdauer-Grenzwert überschreitet, sowie eine Vorrichtung zur Einhaltung des Prüfintervalls für eine Fehlerstrom-Schutzeinrichtung, umfassend einen Betriebsdauerzähler zur Messung einer Betriebsdauer der Fehlerstrom-Schutzeinrichtung und einen Grenzwertvergleicher zur Erkennung einer Überschreitung eines einstellbaren Betriebsdauer-Grenzwertes und zur Ausgabe eines Auslösesignals für eine Alarmmeldung.

Als Schutzmaßnahme in elektrischen Anlagen für den Schutz bei Berühren von Körpern elektrischer Betriebsmittel ist der Einsatz von Fehlerstrom-Schutzeinrichtungen (RCDs - residual current protective device) bekannt und deren Verwendung ist in Sicherheitsnormen festgelegt. Die Wirkungsweise einer derartigen Fehlerstrom-Schutzeinrichtung beruht auf der Tatsache, dass im fehlerfreien Betrieb einer elektrischen Anlage die vektorielle Summe der Ströme auf allen stromführenden Leitern einer Zuleitung gleich Null ist und somit auch kein Magnetfeld in der Umgebung der Zuleitung existiert. Entsteht auf Grund eines Isolationsfehlers ein Fehlerstrom, der außerhalb der Zuleitung über einen Körper bzw. über Erde abfließt, ergibt sich ein Differenzstrom. Dabei werden zur Erkennung des Differenzstromes alle aktiven Leiter der zu schützenden Leitung als Primärwicklung durch einen Messstromwandlerkern geführt, der mit einer Sekundärwicklung ausgestattet ist. Fließt ein Fehlerstrom, z. B. infolge eines Isolationsfehlers, über Erde ab, so fließt durch den Messstromwandler ein Differenzstrom, dessen Magnetfeld im Falle einer zeitlichen Änderung sekundärseitig eine Spannung induziert, die zu einem Sekundärstrom führt, der ein Schaltglied auslöst, das die fehlerbehaftete Zuleitung trennt.

Die zuverlässige Funktion der Fehlerstrom-Schutzeinrichtung über die gesamte Produktlebensdauer hinweg und die damit verbundene Wirksamkeit im Rahmen eines Schutzkonzeptes ist abhängig von der zeitlichen Konstanz der mechanischen und elektrischen Eigenschaften der in der Fehlerstrom-Schutzeinrichtung verbauten Komponenten. Diese erforderliche zeitliche Konstanz kann allerdings von den Herstellern der Fehlerstrom-Schutzeinrichtungen nicht garantiert werden, so dass eine Prüftaste vorgesehen ist, bei deren Betätigung ein künstlicher Fehlerstrom erzeugt wird, der zum Auslösen der Fehlerstrom-Schutzeinrichtung führt.

Gemäß der Unfallverhütungsvorschrift BGV A3 für Elektrische Anlagen und Betriebsmittel ist diese Prüftaste im Rahmen einer Wiederholungsprüfung regelmäßig zu betätigen, wobei das Prüfintervall bei stationären Anlagen 6 Monate beträgt und bei nichtstationären Anlagen ein arbeitstägliches Prüfintervall festgelegt ist.

Bei einer Vielzahl der in einer elektrischen Anlage verbauten Fehlerstrom-Schutzeinrichtungen erfordert die Einhaltung dieser Vorgaben einen erheblichen planerischen Aufwand zur Durchführung der Wartungs- und Prüftätigkeiten. Erfahrungsgemäß kann davon ausgegangen werden, dass die Umsetzung dieser Unfallverhütungsvorschrift im Bereich von Großbetrieben und mittelständischen Unternehmen ordnungsgemäß durchgeführt wird, jedoch in Kleinbetrieben und vor allem im privaten Umfeld vernachlässigt wird. Bislang wurde dem technischen Problem der Sicherstellung der Funktionsfähigkeit einer Fehlerstrom-Schutzeinrichtung lediglich durch eine mehr oder weniger erfolgreiche eigenverantwortliche Planung und Umsetzung der Wiederholungsprüfungen begegnet. Somit kann angenommen werden, dass sich ein gewisser Bestand an nicht mehr funktionsgemäß arbeitenden Fehlerstrom-Schutzeinrichtungen im Einsatz befindet, auf deren Wirksamkeit jedoch ein Schutzkonzept für die jeweilige elektrische Anlage basiert.

Die US-Offenlegungsschrift US 2010/0052691 A1 beschreibt eine Zeitalarmvorrichtung für eine Fehlerstrom-Schutzeinrichtung, die den Benutzer auf die Durchführung eines Integritätstests innerhalb eines vorbestimmten Zeitintervalls hinweist. Mittels einer Meldeeinrichtung wird der Benutzer aufgefordert, durch Drücken einer Prüftaste manuell einen Fehlerstrom zu erzeugen und somit den Fehlerstrom-Schutzschalter auszulösen. Das erfolgreiche Auslösen des Fehlerstrom-Schutzschalters wird durch Messen/Abtasten und Vergleichen der Spannung auf der Lastseite geprüft.

In der weiteren Offenlegungsschrift US 2008/0007879 A1 ist eine Fehlerstrom-Schutzeinrichtung mit einer Testvorrichtung beschrieben, die in periodischen Zeitintervallen einen Selbsttest durchführt. Zur Durchführung des Selbsttests können Leiterspannungen auf der Einspeise- und auf der Lastseite erfasst werden. Weiterhin weist die Vorrichtung unter anderem einen Software-gesteuerten Timer sowie Kommunikationseinrichtungen zur Übermittlung der Testresultate auf.

In den bisher aus dem Stand der Technik bekannten Lösungen kann allerdings nicht gewährleistet werden, dass die Funktionsfähigkeit einer Fehlerstrom-Schutzvorrichtung stets mit hoher Zuverlässigkeit über deren gesamte Lebensdauer sichergestellt ist.

Der vorliegenden Erfindung liegt somit die Aufgabe zu Grunde, durch die Anwendung eines geeigneten Verfahrens und durch eine entsprechende Vorrichtung dazu beizutragen, dass der ordnungsgemäße Zustand und damit die Funktionsfähigkeit einer Fehlerstrom-Schutzeinrichtung über deren gesamte Produktlebensdauer hinweg aufrechterhalten werden kann.

Die Aufgabe wird gelöst durch ein Verfahren zur Überwachung eines Prüfintervalls für eine Fehlerstrom-Schutzeinrichtung umfassend die wiederholt ausgeführten Verfahrensschritte: Messen einer Betriebsdauer der Fehlerstrom-Schutzeinrichtung, Auslösen einer Alarmmeldung, falls die gemessene Betriebsdauer einen Betriebsdauer-Grenzwert überschreitet.

Der Grundgedanke der vorliegenden Erfindung beruht darauf, den Betreiber der elektrischen Anlage rechtzeitig auf den Ablauf eines Prüfintervalls hinzuweisen. Dies geschieht in vorteilhafterweise durch Messen der Betriebsdauer der Fehlerstrom-Schutzeinrichtung in Verbindung mit dem Auslösen einer Alarmmeldung, falls die gemessene Betriebsdauer einen Betriebsdauer-Grenzwert überschreitet. Die Überwachung des Prüfintervalls auf der Grundlage der Messung der Betriebsdauer stellt sicher, dass die vorgeschriebenen Prüfintervalle für die Fehlerstrom-Schutzeinrichtung eingehalten werden und somit die Wirksamkeit eines Schutzkonzeptes für die elektrische Anlage gewährleistet ist. Unabhängig von dem Absetzen der Alarmmeldung wird bei der Erkennung eines Auslösevorgangs der Fehlerstrom-Schutzeinrichtung die Messung der Betriebsdauer neu gestartet, um das nächste Prüfintervall überwachen zu können.

Es werden eine Leiterspannung auf einer Einspeiseseite und eine Leiterspannung auf einer Lastseite der Fehlerstrom-Schutzeinrichtung gemessen und der Neustart der Betriebsdauer-Messung erfolgt in Abhängigkeit der gemessenen Leiterspannungen. Die Betriebsdauer-Messung wird dahingehend automatisiert, dass ein Zurücksetzen und damit ein Neustart der Betriebsdauer-Messung in Abhängigkeit der gemessenen Leiterspannungen erfolgen. Dazu werden auf der Einspeiseseite sowie auf der Lastseite der zu überprüfenden Fehlerstrom-Schutzeinrichtung die jeweiligen Leiterspannungen gemessen. In Abhängigkeit der Messergebnisse wird ein Neustart der Betriebsdauer-Messung durchgeführt, so dass die Überwachung des zeitlich folgenden Prüfintervalls in Gang gesetzt wird. Der Zeitpunkt des Neustarts ergibt sich damit als Funktion der gemessenen Leiterspannungen. Sofern diese bestimmte Bedingungen erfüllen, wird ein Neustart der Betriebsdauer-Messung veranlasst.

Mit Vorteil erfolgt der Neustart der Betriebsdauer-Messung, falls eine Auswertung der gemessenen Leiterspannungen ergibt, dass die Leiterspannung auf der Einspeiseseite den Wert der Netznennspannung aufweist und die Netznennspannung auf der Lastseite abgeschaltet ist. Zeigt also ein Vergleich der gemessenen Leiterspannungen dass bei Vorhandensein einer eingangsseitigen Netznennspannung lastseitig keine Leiterspannung vorhanden ist, so kann davon ausgegangen werden, dass eine Auslösung der Fehlerstrom-Schutzeinrichtung stattgefunden hat - deren Funktionsfähigkeit zu diesem Zeitpunkt somit sichergestellt war. Daraufhin kann durch den Neustart der Betriebsdauer-Messung das zeitlich folgende Prüfintervall überwacht werden.

Als zweckmäßig erweist sich, dass der Betriebsdauer-Grenzwert einstellbar ist. Durch die Einstellbarkeit des Betriebsdauer-Grenzwertes kann eine Anpassung der Betriebsdauer-Messung an vorgeschriebene Prüfintervalle vorgenommen werden. So kann beispielsweise im Rahmen der in der Unfallverhütungsvorschrift BGV A3 vorgegebenen Wiederholungsprüfungen durch entsprechende Einstellung des Betriebsdauer-Grenzwertes rechtzeitig auf den Ablauf des 6-monatigen Prüfintervalls für stationäre Anlagen hingewiesen werden, ebenso ist es mit der Erfindung möglich, durch Einstellung des Betriebsdauer-Grenzwertes auf einen kleineren Wert beispielsweise ein arbeitstägliches Prüfintervall für nichtstationäre Anlagen zu überwachen.

Als Alarmmeldung kann ein akustisch und/oder optisch wahrnehmbares Signal ausgesendet werden, um den Betreiber der elektrischen Anlage rechtzeitig auf eine anstehende Wiederholungsprüfung aufmerksam zu machen.

Von Vorteil ist weiterhin, dass bei Auslösen einer Alarmmeldung ein Schaltkontakt betätigt und/oder eine drahtgebundene Schnittstelle und/oder eine drahtlose Schnittstelle angesteuert wird. Auf diese Weise kann die Alarmmeldung über eine anstehende Wiederholungsprüfung an entsprechende Stellen zur Ergreifung weiterer Maßnahmen weitergeleitet werden.

In Bezug auf eine Vorrichtung wird die Aufgabe gelöst durch eine Überwachungseinrichtung zur Einhaltung eines Prüfintervalls für eine Fehlerstrom-Schutzeinrichtung, die einen Betriebsdauerzähler zur Messung einer Betriebsdauer der Fehlerstrom-Schutzeinrichtung und einen Grenzwertvergleicher zur Erkennung einer Überschreitung eines einstellbaren Betriebsdauer-Grenzwertes und zur Ausgabe eines Auslösesignals für eine Alarmmeldung aufweist.

Korrespondierend zu dem erfindungsgemäßen Verfahren weist die erfindungsgemäße Überwachungseinrichtung einen Betriebsdauerzähler auf, der die Betriebsdauer der Fehlerstrom-Schutzeinrichtung misst und dessen Zählerstand proportional zur Betriebsdauer der Fehlerstrom-Schutzeinrichtung seit dem letzten Neustart (Rücksetzung) ist. Der Zählerstand des Betriebsdauerzählers wird von einem Grenzwertvergleicher mit einem voreingestellten Betriebsdauer-Grenzwert verglichen. Im Falle der Überschreitung des Betriebsdauer-Grenzwertes gibt der Grenzwertvergleicher ein Auslösesignal für eine Alarmmeldung aus.

In vorteilhafter Ausgestaltung weist die Überwachungseinrichtung einen Spannungsdetektor zur Erkennung einer Leiterspannung auf einer Einspeiseseite der Fehlerstrom-Schutzeinrichtung und einen Differenzdetektor zur Erkennung einer Differenz der Leiterspannungen zwischen der Einspeiseseite und einer Lastseite der Fehlerstrom-Schutzeinrichtung und zur Erzeugung eines Rückstellsignals für den Betriebsdauerzähler auf.

Der Spannungsdetektor erkennt die Leiterspannung auf der Einspeiseseite der Fehlerstrom-Schutzschaltung und gibt den Zählvorgang des Betriebsdauerzählers frei. Der Differenzdetektor erhält von dem Spannungsdetektor ein Statussignal über die einspeiseseitig anliegende Leiterspannung und prüft gleichzeitig die lastseitige Leiterspannung. Ergibt die Prüfung, dass die Leiterspannung auf der Einspeiseseite den Wert der Netznennspannung aufweist und die Netznennspannung auf der Lastseite abgeschaltet ist, so erzeugt der Differenzdetektor ein Rückstellsignal für den Betriebsdauerzähler, um mit einem Neustart des Betriebsdauerzählers ein neues Prüfintervall überwachen zu können.

Die Überwachungseinrichtung weist einen Alarmgeber auf, der das Auslösesignal des Grenzwertvergleichers empfängt und eine Alarmmeldung aussendet und/oder weiterleitet. Dabei kann der Alarmgeber als Warneinrichtung zur Aussendung akustisch und/oder optisch wahrnehmbarer Signale ausgeführt sein. Auch eine Ausführung als Schaltkontakt und/oder drahtgebundene Schnittstelle und/oder drahtlose Schnittstelle ist vorteilhaft, um die Information über eine durchzuführende Wiederholungsprüfung weiterzuleiten.

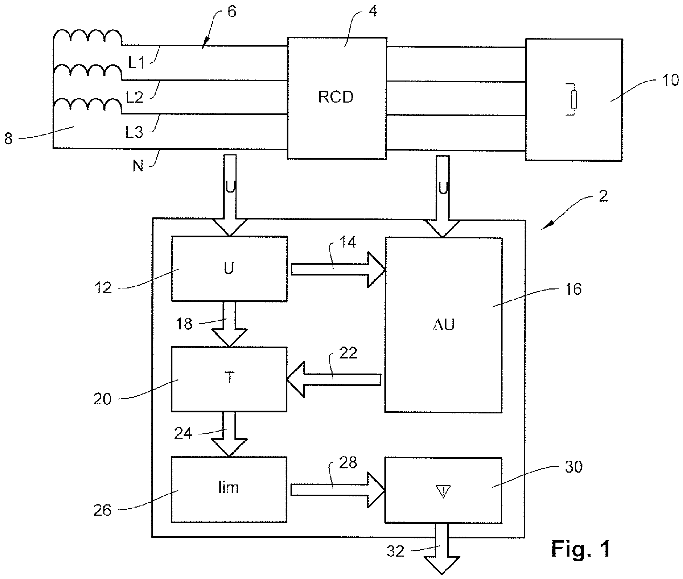

Weitere vorteilhafte Ausgestaltungsmerkmale ergeben sich aus der nachfolgenden Beschreibung und den Zeichnungen, die bevorzugte Ausführungsformen der Erfindung an Hand von Beispielen erläutern. Es zeigt die
- **Fig. 1:**: ein funktionales Blockschaltbild der erfindungsgemäßen Überwachungseinrichtung.

**Fig. 1** zeigt ein funktionales Blockschaltbild einer erfindungsgemäßen Überwachungseinrichtung 2 im Verbund mit einer zu überprüfenden Fehlerstrom-Schutzeinrichtung 4 in einem mehrphasigen Stromversorgungssystem 6. Die Fehlerstrom-Schutzeinrichtung 4 ist in dem Stromversorgungssystem 6 zwischen einem Einspeisepunkt 8 des Stromversorgungssystems 6 und einer Last 10 angeordnet.

Die Überwachungseinrichtung 2 umfasst einen Spannungsdetektor 12, der auf der Einspeiseseite der Fehlerstrom-Schutzeinrichtung 4 eine Spannung an einem der aktiven Leiter L1, L2, L3 oder N des Stromversorgungsnetzes 6 abgreift und eine Statusinformation 14 über den einspeiseseitigen Spannungszustand (Netznennspannung vorhanden/nicht vorhanden) an einen Differenzdetektor 16 der Überwachungseinrichtung 2 weiterleitet. Ist einspeiseseitig eine Netznennspannung festgestellt, so sendet der Spannungsdetektor 12 ein Freigabesignal 18 an einen Betriebsdauerzähler 20 der Überwachungseinrichtung 2, um den Zählvorgang freizugeben. Der Differenzdetektor 16 stellt fest, ob auch lastseitig eine Netznennspannung vorhanden ist und gibt in dem Fall, dass zwar einspeiseseitig eine Netznennspannung erkannt wird, aber lastseitig die Netznennspannung nicht vorhanden ist, ein Rückstellsignal 22 an den Betriebsdauerzähler 20 aus, um diesen neu zu starten. Der Betriebsdauerzähler 20 leitet den aktuellen Zählerstand 24 an einen Grenzwertvergleicher 26 der Überwachungseinrichtung 2 weiter. Stellt der Grenzwertvergleicher 26 fest, dass der aktuelle Zählerstand 24 einen voreingestellten Betriebsdauer-Grenzwert überschreitet, so gibt der Grenzwertvergleicher 26 ein Auslösesignal an einen Alarmgeber 30 der Überwachungseinrichtung 2 aus, um diesen zur Aussendung einer Alarmmeldung 32 oder zur Weiterleitung der Information über eine anstehende Wiederholungsprüfung zu veranlassen.

## Patentansprüche

1. Verfahren zur Überwachung eines Prüfintervalls für eine Fehlerstrom-Schutzeinrichtung (4), umfassend die wiederholt ausgeführten Verfahrensschritte:
- Messen einer Betriebsdauer der Fehlerstrom-Schutzeinrichtung (4),
- Auslösen einer Alarmmeldung (32), falls die gemessene Betriebsdauer einen Betriebsdauer-Grenzwert überschreitet,
**gekennzeichnet durch**
- Neustarten der Betriebsdauer-Messung bei Erkennen eines Auslösevorgangs der Fehlerstrom-Schutzeinrichtung (4), wobei eine Leiterspannung auf einer Einspeiseseite und eine Leiterspannung auf einer Lastseite der Fehlerstrom-Schutzeinrichtung (4) gemessen werden und der Neustart der Betriebsdauer-Messung in Abhängigkeit der gemessenen Leiterspannungen erfolgt, falls eine Auswertung der gemessenen Leiterspannungen ergibt, dass die Leiterspannung auf der Einspeiseseite den Wert der Netznennspannung aufweist und die Netznennspannung auf der Lastseite abgeschaltet ist.

2. Verfahren nach Anspruch 1,
**dadurch gekennzeichnet,**
**dass** der Betriebsdauer-Grenzwert einstellbar ist.

3. Verfahren nach Anspruch 1 oder 2,
**dadurch gekennzeichnet,**
**dass** als Alarmmeldung (32) ein akustisch und/oder optisch wahrnehmbares Signal ausgesendet wird.

4. Verfahren nach einem der Ansprüche 1 bis 3,
**dadurch gekennzeichnet,**
**dass** bei Auslösen einer Alarmmeldung (32) ein Schaltkontakt betätigt und/oder eine drahtgebundene Schnittstelle und/oder eine drahtlose Schnittstelle angesteuert wird.

5. Überwachungseinrichtung (2) zur Einhaltung eines Prüfintervalls für eine Fehlerstrom-Schutzeinrichtung (4), umfassend einen Betriebsdauerzähler (20) zur Messung einer Betriebsdauer der Fehlerstrom-Schutzeinrichtung (4) und einen Grenzwertvergleicher (26) zur Erkennung einer Überschreitung eines einstellbaren Betriebsdauer-Grenzwertes und zur Ausgabe eines Auslösesignals (28) für eine Alarmmeldung (32),
**gekennzeichnet durch**
einen Spannungsdetektor (12) zur Erkennung einer Leiterspannung auf einer Einspeiseseite der Fehlerstrom-Schutzeinrichtung (4), einen Differenzdetektor (16) zur Erkennung einer Differenz der Leiterspannungen zwischen der Einspeiseseite und einer Lastseite der Fehlerstrom-Schutzeinrichtung (4) und zur Erzeugung eines Rückstellsignals (22) für den Betriebsdauerzähler (20).

6. Überwachungseinrichtung (2, 34) nach Anspruch 5,
**gekennzeichnet durch**
einen Alarmgeber (30), der das Auslösesignal (28) des Grenzwertvergleichers (26) empfängt und eine Alarmmeldung (32) aussendet und/oder weiterleitet.

7. Überwachungseinrichtung (2, 34) nach Anspruch 5 oder 6,
**dadurch gekennzeichnet,**
**dass** der Alarmgeber (30) als Warneinrichtung zur Aussendung akustisch und/oder optisch wahrnehmbarer Signale ausgeführt ist.

8. Überwachungseinrichtung (2, 34) nach einem der Ansprüche 5 bis 7,
**dadurch gekennzeichnet,**
**dass** der Alarmgeber (30) als Schaltkontakt und/oder drahtgebundene Schnittstelle und/oder drahtlose Schnittstelle ausgeführt ist.

## Claims

1. A method for monitoring a test interval for a residual current protective device (4), comprising the repeatedly performed method steps of:
- measuring an operating time of the residual current protective device (4),
- triggering an alarm report (32) if the measured operating time exceeds an operating time limit,
**characterized by**
- restarting the operating time measurement upon detection of a trigger process of the residual current protective device (4), a line voltage being measured on a supply side and a line voltage being measured on a load side of the residual current protective device (4) and the restart of the operating time measurement taking place as a function of the measured line voltages if an evaluation of the measured line voltages reveals that the line voltage on the supply side has the value of the nominal system voltage and the nominal system voltage on the load side is switched off.

2. The method according to claim 1,
**characterized in that**
the operating time limit is adjustable.

3. The method according to claim 1 or 2,
**characterized in that**
an acoustically and/or optically perceptible signal is sent out as the alarm report (32).

4. The method according to any one of claims 1 to 3,
**characterized in that**
when an alarm report (32) is triggered, a switching contact is actuated and/or a wired interface and/or a wireless interface is activated.

5. A monitoring device (2) for maintaining a test interval for a residual current protective device (4), comprising an operating time counter (20) for measuring an operating time of the residual current protective device (4) and a limit comparator (26) for detecting an exceedance of an adjustable operating time limit and for sending out a trigger signal (28) for an alarm report (32),
**characterized by**
a voltage detector (12) for detecting a line voltage on a supply side of the residual current protective device (4), a difference detector (16) for detecting a difference in the line voltages between the supply side and a load side of the residual current protective device (4) and for generating a reset signal (22) for the operating time counter (20).

6. The monitoring device (2, 34) according to claim 5,
**characterized by**
an alarm generator (30), which receives the trigger signal (28) of the limit comparator (26) and sends out and/or transmits an alarm report (32).

7. The monitoring device (2, 34) according to claim 5 or 6,
**characterized in that**
the alarm generator (30) is implemented as a warning device for sending out acoustically and/or optically perceptible signals.

8. The monitoring device (2, 34) according to any one of claims 5 to 7,
**characterized in that**
the alarm generator (30) is implemented as a switching contact and/or as a wired interface and/or as a wireless interface.

## Revendications

1. Procédé de surveillance d'un intervalle de contrôle pour un dispositif de protection à courant différentiel-résiduel (4), comprenant les étapes de procédé suivantes effectuées de manière répétée :
- mesurer une durée de fonctionnement du dispositif de protection à courant différentiel-résiduel (4),
- déclencher une alarme (32) si la durée de fonctionnement mesurée dépasse une limite de durée de fonctionnement,
**caractérisé par**
- redémarrer la mesure de la durée de fonctionnement quand un déclenchement du dispositif de protection à courant différentiel-résiduel (4) est détecté, une tension de ligne sur un côté d'alimentation et une tension sur un côté de charge du dispositif de protection à courant différentiel-résiduel (4) étant mesurées et le redémarrage de la mesure de la durée de fonctionnement s'effectuant en fonction des tensions de ligne mesurées si une évaluation des tensions de ligne mesurées montre que la tension de ligne sur le côté d'alimentation a la valeur de la tension nominale du réseau et la tension nominale du réseau sur le côté de charge est déconnectée.

2. Procédé selon la revendication 1,
**caractérisé en ce que**
la limite de durée de fonctionnement est ajustable.

3. Procédé selon la revendication 1 ou 2,
**caractérisé en ce qu'**
un signal perceptible de manière acoustique et/ou visuelle est émis comme alarme (32).

4. Procédé selon l'une quelconque des revendications 1 à 3,
**caractérisé en ce qu'**
un contact de commutation est actionné et/ou une interface câblée et/ou une interface sans fil est activée quand une alarme (32) est déclenchée.

5. Dispositif de surveillance (2) pour le respect d'un intervalle de contrôle pour un dispositif de protection à courant différentiel-résiduel (4), comprenant un compteur de durée de fonctionnement (20) destiné à mesurer une durée de fonctionnement du dispositif de protection à courant différentiel-résiduel (4) et un comparateur de limite (26) destiné à détecter un dépassement d'une limite de durée de fonctionnement ajustable et à émettre un signal de déclenchement (28) pour une alarme (32),
**caractérisé par**
un détecteur de tension (12) destiné à détecter une tension de ligne sur un côté d'alimentation du dispositif de protection à courant différentiel-résiduel (4), un détecteur de différence (16) destiné à détecter une différence des tensions de ligne entre le côté d'alimentation et un côté de charge du dispositif de protection à courant différentiel-résiduel (4) et à générer un signal de rappel (22) pour le compteur de durée de fonctionnement (20).

6. Dispositif de surveillance (2, 34) selon la revendication 5,
**caractérisé par**
un émetteur d'alarme (30), qui reçoit le signal de déclenchement (28) du comparateur de limite (26) et émet et/ou transmet une alarme (32).

7. Dispositif de surveillance (2, 34) selon la revendication 5 ou 6,
**caractérisé en ce que**
l'émetteur d'alarme (30) est réalisé comme dispositif d'avertissement destiné à émettre des signaux perceptibles de manière acoustique et/ou visuelle.

8. Dispositif de surveillance (2, 34) selon l'une quelconque des revendications 5 à 7,
**caractérisé en ce que**
l'émetteur d'alarme (30) est réalisé comme contact de commutation et/ou interface câblée et/ou interface sans fil.
